(19) **Europäisches Patentamt**
**European Patent Office**
**Office européen des brevets**

(11) **EP 2 467 909 B1**

(12) **EUROPÄISCHE PATENTSCHRIFT**

(45) Veröffentlichungstag und Bekanntmachung des Hinweises auf die Patenterteilung:
**20.07.2016   Patentblatt 2016/29**

(21) Anmeldenummer: **10755118.6**

(22) Anmeldetag: **23.08.2010**

(51) Int Cl.:
*H01S 5/125* (2006.01)     *H01S 5/10* (2006.01)
*H01S 5/20* (2006.01)

(86) Internationale Anmeldenummer:
**PCT/EP2010/062256**

(87) Internationale Veröffentlichungsnummer:
**WO 2011/020923 (24.02.2011 Gazette 2011/08)**

(54) **DIODENLASER UND LASERRESONATOR FÜR EINEN DIODENLASER MIT VERBESSERTER LATERALER STRAHLQUALITÄT**

DIODE LASER AND LASER RESONATOR FOR A DIODE LASER HAVING IMPROVED LATERAL BEAM QUALITY

LASER À DIODE ET RÉSONATEUR DE LASER POUR UN LASER À DIODE DOTÉ D'UNE QUALITÉ D'ÉMISSION LATÉRALE AMÉLIORÉE

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **21.08.2009   DE 102009028823**

(43) Veröffentlichungstag der Anmeldung:
**27.06.2012   Patentblatt 2012/26**

(73) Patentinhaber: **Forschungsverbund Berlin E.V.**
**12489 Berlin (DE)**

(72) Erfinder:
  • **ERBERT, Götz**
    **12557 Berlin (DE)**
  • **SPREEMANN, Martin**
    **13359 Berlin (DE)**
  • **WENZEL, Hans**
    **12355 Berlin (DE)**
  • **FRICKE, Jörg**
    **10319 Berlin (DE)**

(74) Vertreter: **Gulde & Partner**
**Patent- und Rechtsanwaltskanzlei mbB**
**Wallstraße 58/59**
**10179 Berlin (DE)**

(56) Entgegenhaltungen:
**US-A- 5 894 492**

• **NIKLAS ERIKSSON ET AL: "Surface-Emitting Unstable-Resonator Lasers with Integrated Diffractive Beam-Forming Elements", IEEE PHOTONICS TECHNOLOGY LETTERS, IEEE SERVICE CENTER, PISCATAWAY, NJ, US, Bd. 9, Nr. 12, 1. Dezember 1997 (1997-12-01), XP011048989, ISSN: 1041-1135**
• **KRISTJANSSON S ET AL: "SURFACE -EMITTING TAPERED UNSTABLE RESONATOR LASER WITH INTEGRATED FOCUSING GRATING COUPLER", IEEE PHOTONICS TECHNOLOGY LETTERS, IEEE SERVICE CENTER, PISCATAWAY, NJ, US, Bd. 12, Nr. 10, 1. Oktober 2000 (2000-10-01), Seiten 1319-1321, XP000970124, ISSN: 1041-1135, DOI: 10.1109/68.883816**
• **BEDFORD ROBERT ET AL: "Demonstration of finite-aperture tapered unstable resonator lasers", APPLIED PHYSICS LETTERS, AIP, AMERICAN INSTITUTE OF PHYSICS, MELVILLE, NY, US, Bd. 83, Nr. 5, 4. August 2003 (2003-08-04) , Seiten 822-824, XP012035651, ISSN: 0003-6951, DOI: 10.1063/1.1598292 in der Anmeldung erwähnt**
• **M SPREEMANN ET AL: "Novel approach to finite aperture tapered unstable resonator lasers", IEEE JOURNAL OF QUANTUM ELECTRONICS IEEE USA, Bd. 47, Nr. 1, 31. Oktober 2011 (2011-10-31), Seiten 117-125, XP002662584, ISSN: 0018-9197, DOI: DOI:10.1109/JQE.2010.2081969**

EP 2 467 909 B1

**Beschreibung**

Die vorliegende Erfindung betrifft einen Diodenlaser und Laserresonator für einen Diodenlaser mit verbesserter lateralen Strahlqualität ohne Verwendung eines externen Resonators, insbesondere betrifft die vorliegende Erfindung einen Breitstreifenlaser mit hohen Ausgangsleistungen >1W. Ein Breitstreifenlaser hat typischerweise eine Kontaktbreite von 10$\mu$m bis 500$\mu$m und eine Resonatorlänge von 0,5mm bis 10mm.

Stand der Technik

Mit Breitstreifenlasern (BA-Lasern) werden hohe Leistungen erzielt. Die große laterale Ausdehnung des Wellenleiters ermöglicht jedoch das gleichzeitige Anschwingen vieler lateraler Moden. Zusätzlich kommt es durch die starke Kopplung von optischer Intensität und Materialverstärkung zur Ausbildung von lokalen Wellenleitern, so genannten Filamenten. Beide Effekte reduzieren die räumliche Kohärenz und die Strahlqualität.

Um die optische Leistung zu vergrößern ohne die Strahlqualität zu verringern gibt es eine Vielzahl von Ansätzen:

- Laterale Strukturierung der Strominjektion eines Breitstreifenlasers oder die kohärente Kopplung mehrer schmaler Streifenlaser

- Laterale Modenselektion durch "winkelabhängige Reflexion", z.B. durch schräge Facetten (Tilted-Cavity Laser TCL) oder schräge Bragg-Reflektoren ($\alpha$-DFB) -Laser)

- Instabile Laser-Resonatoren basierend auf

    a) gekrümmten Facetten

    b) gekrümmten Bragg-Gittern

- Monolithische Kombination eines lateral einmodigen Rippenwellenleiter-Lasers (master oscillator) mit einem breitflächigen, trapezförmigen Leistungsverstärker zu einem Trapez- Master-Oscillator Power-Amplifier (MOPA) -System

- Trapezförmiges Resonatordesign mit integriertem Rippenwellenleiter als lateralen Modenfilter (Trapezlaser)

Bei den ersten drei genannten Ansätzen konnte bei kleinen Leistungen (<5 W) teilweise eine Verbesserung der Strahlqualität im Vergleich zum herkömmlichen Breitstreifenlaser erreicht werden. Höhere optische Leistungen sind mit diesen Ansätzen jedoch entweder nicht erreicht worden, oder bei hohen Leistungen versagten die Mechanismen der lateralern Modenkontrolle und die Strahlqualität war schlechter als bei herkömmlichen Breitstreifenlasern.

Im Falle eines instabilen Laserresonators mit gekrümmten Facetten ist vor allem die Rauheit der meist geätzten Facetten zu groß. Im Falle gekrümmter Bragg-Gitter ist die korrekte Phasenanpassung der an den gekrümmten Gittern reflektierten Teilwellen problematisch. Der Krümmungsradius jedes einzelnen Gittergrabens muss unterschiedlich gewählt werden, was mit einem erhöhten Fertigungsaufwand einher geht.

Nachteilig an MOPA-Systemen ist, dass bei gleicher Gesamtlänge die effektive Pumpfläche im Vergleich zum Breitstreifenlaser deutlich kleiner ist. Der elektrische Serienwiderstand und der thermische Widerstand eines Diodenlasers sind aber antiproportional zur Pumpfläche. Der Konversionsgrad, d.h. das Verhältnis von ausgekoppelter optischer Leistung zu zugeführter elektrischer Leistung eines Trapez-MOPAs ist daher deutlich geringer als der eines BA-Lasers. Die Verlustleistung wird als Wärme freigesetzt. Gleichzeitig steigt die Temperatur im Trapez-MOPA durch den erhöhten thermischen Widerstands bei gleicher Erwärmung stärker an und der temperaturabhängige optische Gewinn nimmt stärker ab als bei BA-Lasern. Dieser Effekt wird als thermisches Überrollen bezeichnet und begrenzt die optische Leistung von Trapez-MOPAs schon bei deutlich geringen Pumpströmen als bei BA-Lasern. Weiterhin ist der Astigmatismus, d.h. der Abstand der Laserstrahl-Taillen in der "fast-" und "slow axis" stark vom Arbeitspunkt (Pumpstrom & Temperatur) abhängig. Ein optisches System hinter dem Laser muss also für verschiedene Arbeitspunkte unterschiedlich aufgebaut werden. Darüber hinaus führt bereits eine minimale Rückkopplung von Laserlicht von der Frontfacette in den Master-Oscillator zu einer Störung des stabilen Laserbetriebs und kann ungewollte Pulsationen und chaotische dynamische Zustände hervorrufen.

Auch mit Trapezlasern können Leistungen >5W mit im Vergleich zum BA-Laser deutlich verbesserter Strahlqualität realisiert werden. Bis auf die Empfindlichkeit auf interne Rückkopplung treten die gleichen Nachteile wie bei Trapez-MOPAs auf. Hinzu kommt, dass aufgrund der lateral homogen reflektierenden Frontfacette unnötig hohe Verluste in den ungepumpten Trapezteil entstehen.

Aus Eriksson et al. "Surface-Emitting Unstable Resonator Lasers with Integrated Diffractive Beam-Forming Elements", IEEE Photonics Technology Letters, vol.9, No. 12, dec 1997 pp1570-1572 ist ein instabiler DBR-Trapezlaser mit konfokalen räumlich begrensten Gittern bekannt.

Weiterhin sind aus Bedford et al. "Demonstration of finite-aperture tapered unstable resonator lasers", Applied Physics Letters, Vol. 83, No. 5, DBR-Trapezlaser mit räumlich begrenztem planeren Oberflächengittern als Frontreflektivität bekannt, um die optischen Verluste durch Abstrahlung in den ungepumpten Trapezteil zu minimieren. Dabei wird die Modenfilterung notwendigerweise durch eine Sektion mit Rippenwellenleiter erzeugt, wodurch die Pumpfläche stark begrenzt ist.

Zur Verbesserung der lateralen Strahlqualität ist es weiterhin bekannt den Laserresonator extern aufzubauen und in diesen einen Halbleiterlaserverstärker (SOA) zu integrieren. Nachteile des hybriden Aufbaus sind jedoch die sehr hohe Justagegenauigkeit der optischen Elemente (<1 μm), die geringe mechanische und thermische Stabilität sowie die aufwändige Herstellung.

Es ist daher Aufgabe der vorliegenden Erfindung, einen Diodenlaser und einen Laserresonator für einen Diodenlaser anzugeben, der bei hohen Ausgangsleistungen eine hohe laterale Strahlqualität aufweist, einen geringen Justageaufwand erfordert und preiswert herstellbar ist. Weiterhin soll der erfindungsgemäß Diodenlaser ohne Verwendung eines externen Resonators einer hohen lateralen Strahlqualität liefern.

Beschreibung der Erfindung

Diese Aufgaben werden erfindungsgemäß durch die Merkmale des Patentanspruchs 1 gelöst. Bevorzugte Ausgestaltungen der Erfindung sind in den Unteransprüchen enthalten.

Die Idee der Erfindung besteht darin, die Propagationsfaktoren einzelner lateraler Moden durch geeignete Wahl der unterschiedlichen Gitterbreiten der an den Facetten des Resonators angeordneten Bragg Reflektoren (sog. "DBR - Spiegel" oder auch "Distributed Bragg Reflector") derart zu beeinflussen, dass lateralen Moden höherer Ordnung(en) als die laterale Grundmode derart unterdrückt werden, dass sie nicht zu einem stabilen Laserbetrieb gelangen können. Es wurde.gefunden, dass die Variation des Verhältnisses der Gitterbreiten der an den Facetten des Resonators angeordneten Bragg Reflektoren zu einer unterschiedlichen Modulation der einzelner Propagationsfaktoren lateraler Moden (auch in Abhängigkeit der Resonatorlänge und der Dimensionen und Materialien des Wellenleiters und der Gewinnsektion) führt, so dass durch geeignete Wahl des Verhältnisses der Gitterbreiten die Intensität der lateralen Grundmode gegenüber lateralen Moden höherer Ordnungen und somit die laterale Strahlqualität deutlich erhöht werden kann. So ist es insbesondere möglich, einen strukturell einfachen Diodenlaser (Resonator) mit hoher lateraler Strahlqualität zu realisieren, da selbst bei sehr hohen Leistungen auf die Verwendung gekrümmter Facetten, gekrümmter Bragg Reflektoren oder externer Resonator verzichtet werden kann. Weiterhin kann auf einen zwischen den Facetten (Bragg Reflektoren) angeordneten Rippenwellenleiter zur Modenselektion verzichtet werden, da die Modenselektion durch das Verhältnis der Gitterbreiten eingestellt werden kann, wodurch vorteilhafterweise eine größere Pumpfläche zur Verfügung steht. Mit anderen Worten ist im Bereich zwischen dem ersteh Bragg Reflektor und dem zweiten Bragg Reflektor kein Rippenwellenleiter angeordnet.

Gemäß einem Aspekt der Erfindung wird ein Laserresonator für eine Laserdiode offenbart, aufweisend: eine Gewinnsektion, einen ersten planaren Bragg Reflektor und einen zweiten planaren Bragg Reflektor, wobei die Gewinnsektion zwischen dem ersten planaren Bragg Reflektor und dem zweiten planaren Bragg Reflektor angeordnet sind, und wobei die gesamte Gewinnsektiori gewinngeführt ausgebildet ist, und sich die Breite des ersten planaren Bragg Reflektors von der Breite des zweiten planaren Bragg Reflektors unterscheidet. Vorzugsweise beträgt das Verhältnis der Breite des zweiten planaren Bragg Reflektors zur Breite des ersten planaren Bragg Reflektors zwischen 1,5 und 20. Vorzugsweise ist die Gewinnsektion durch genau eine (zusammenhängende) Gewinnsektion ausgebildet. Alternativ ist es möglich, die Gewinnsektion in mehrere Unterbereiche zu unterteilen, in die Ladungsträger jeweils durch separate Kontakte injiziert werden. Im Falle mehrerer Unterbereiche ist jeder dieser Unterbereiche gewinngeführt (also nicht indexgeführt) ausgebildet.

Dass die gesamte Gewinnsektion gewinngeführt (also nicht indexgeführt) ausgebildet ist, wird in der vorliegenden Anmeldung gemäß der Definition verstanden, wie sie in M. Ueno und H. Yonezu: "Guiding mechanisms controlled by impurity concentrations - (Al,Ga)As planar stripe laser with deep Zn diffusion", J. Appl. Phys. 51 (5) S. 2361-2371 (1980) offenbart ist. Dort werden die Bereiche der Gewinnführung und der Indexführung in Abhängigkeit eines Parameters D definiert:

$$D = \frac{\Delta\alpha}{2k_0\Delta n} \quad \text{mit} \quad k_0 = \frac{2\pi}{\lambda_0} \quad (\text{Vakuumwellenlänge})$$

Indexführung wird als "normal guiding" bezeichnet, das nach M. Yamada: "Transverse and Longitudinal Mode Control in Semiconductor Injection Lasers", J. Quant. Electron. QE-19 (9) S. 1365 - 1380 (1983), S. 1368, Tab. 1 äquivalent zum Begriff "index guiding" (Indexführung) ist. Das Kriterium für Gewinnführung ("gain guiding") ist, dass der Betrag von D größer als 1 ist. Für einen typischen Wert der Gewinn-Verlust-Differenz $\Delta\alpha$ = 10 cm$^{-1}$ für Hochleistungsdiodenlaser und eine typische Vakuumwellenlänge von $\lambda_0$ = 1 $\mu$m folgt daraus für den Sprung (Differenz) der effektiven Indices $\Delta$n < 1,5 $\times$ 10$^{-4}$. Dies kann dadurch realisiert werden, seitlich des Kontaktes nicht oder nur hinreichend flach (vorzugsweise maximal bis 500 nm an die aktive Schicht heran) geätzt wird.

Im Gegensatz zur Gewinnsektion der vorliegenden Erfindung, sind durch Rippenwellenleiter ausgebildete Gewinnsektionen indexgeführt. Dort werden Gräben bis in die Wellenleiterschicht geätzt. Der entstehende Indexsprung führt zur lateralen (senkrecht zur Ausbreitungsrichtung und zur epitaktischen Wachstumsrichtung) Wellenleitung im nicht-geätzten (meist elektrisch gepumpten) Bereich zwischen den Gräben. Beim Rippenwellenleiter laufen die Furchen also in Ausbreitungsrichtung, beim Bragg Reflektor senkrecht dazu

Die Bragg Reflektoren bestehen aus Gitterfurchen mit geradlinigen (d.h. nicht gekrümmten) Kanten entlang einer Achse senkrecht zur Lichtausbreitungsrichtung, parallel zur Ebene der epitaktischen Schichten. Vorzugsweise sind die Kanten der Gitterfurchen ebenfalls geradlinig entlang einer Achse senkrecht zur Lichtausbreitungsrichtung und senkrecht zur Ebene der epitaktischen Schichten ausgebildet.

Vorzugsweise ist der erste planare Bragg Reflektor an einer ersten Grundseite der Gewinnsektion und der zweite planare Bragg Reflektor ist an der gegenüberliegenden Grundseite der Gewinnsektion angeordnet. Mit anderen Worten ist der erste planare Bragg Reflektor (zumindest teilweise) innerhalb der (oberen) Wellenieiterschicht angeordnet, wobei der erste planare Bragg Reflektor die erste (d.h. die,breitere) Grundseite der Gewinnsektion im Bereich des Wellenleiters vorzugsweise direkt berührt. Weiterhin ist der zweite planare Bragg Reflektor ebenfalls (zumindest teilweise) innerhalb der (oberen) Wellenleiterschicht angeordnet, wobei der zweite planare Bragg Reflektor die zweite (d.h. die schmalere) Grundseite der Gewinnsektion im Bereich des Wellenleiters vorzugsweise direkt berührt. Die aktive Schicht erstreckt sich vorzugsweise über das gesamte Bauelement, wird jedoch nur in der Gewinnsektion durch elektrische Kontaktierung elektrisch gepumpt. Ein direktes Berühren von Bragg Reflektor und Grundseite der Gewinnsektion bedeutet daher, dass sich Bragg-Reflektor und elektrischer Kontakt entlang einer Achse senkrecht zu den Schichten berühren bzw. dass sich Bragg-Reflektor und die Projektion von elektrischem Kontakt in die Ebene des Bragg-Reflektors entlang einer Achse senkrecht zu den Schichten überlappen. Es ist alternativ auch möglich, dass die aktive Schicht unter den Gittern (in einer Projektion entlang der genannten senkrechten Achse) entfernt wird, um die Absorptionsverluste zu minimieren.

Eine Trapezform der Gewinnsektion ist bevorzugt, jedoch nicht zwingend notwendig. Aufgrund der Divergenz des Lichts ist jedoch eine Öffnung zur Frontfacette hin bevorzugt. Es sind aber auch trompetenförmige Geometrien denkbar. Rechteckige Kontaktflächen sind ebenfalls möglich, auch wenn sich aufweitende Kontaktfläche bevorzugt sind.

Vorzugsweise liegt das Verhältnis der Breite des zweiten planaren Bragg Reflektors zur Breite des ersten planaren Bragg Reflektors im Bereich zwischen 1,5 und 20, noch bevorzugter im Bereich zwischen 3 und 10 und noch bevorzugter im Bereich zwischen 3 und 9.

Unter einem Bragg Reflektor wird ein Gitter mit periodischer Variation der Brechzahl zwischen zwei Werten und entlang der Längsachse des Resonators verstanden, wobei die Periodenlänge und Brechzahlen derart gewählt sind, dass die Zentralwellenlänge des Bragg Reflektors im Verstärkungsspektrum der Gewinnsektion liegt.

Vorzugsweise ist die Gewinnsektion trapezförmig ausgebildet, wobei die laterale Wellenleitung vorzugweise gewinngeführt realisiert ist. Gewinnführung basiert auf der lateralen Variation des Gewinns durch eine lateral inhomogene Verteilung der Ladungsträger. Es wird kein lateraler Sprung im Realteil des Brechungsindex zur Wellenleitung eingebaut ($\Delta$n$\approx$0). Vorzugsweise sind der erste planare Bragg Reflektor an einem ersten Ende der Gewinnsektion und der zweite planaren Bragg Reflektor an einem zweiten Ende der Gewinnsektion angeordnet, wobei das zweiten Ende der Gewinnsektion dem ersten Ende gegenüberliegt. Vorzugsweise bestehen die Gewinnsektion und die Wellenleiterschichten aus einem halbleitenden Material. Vorzugsweise sind die planaren Bragg Reflektoren jeweils innerhalb der vom Substrat aus gesehenen oberen Wellenleiterschicht angeordnet. Sofern die Bragg Reflektoren als Oberflächengitter in die zuvor prozessierten Schichten des Resonators eingeätzt werden, erstrecken sich die Bragg Reflektoren jeweils über mindestens einen Teil der oberen Wellenleiterschicht, die Mantelschicht sowie die Kontaktschicht. Sofern die Bragg Reflektoren gleichzeitig bzw. während des Aufbringens der einzelnen Resonatorschichten als jeweils eingeschlossenes Gitter erzeugt werden, befinden sich diese lediglich innerhalb einer der Wellenleiterschichten. Bevorzugt erstrecken sich diese eingeschlossenen Gitter über einen Teilbereich der oberen Wellenleiterschicht.

Vorzugsweise sind die Facetten in bezug auf die spezifische Laserwellenlänge der Gewinnsektion entspiegelt, so dass lediglich die Bragg Reflektoren die Reflexion der lateralen Lasermoden innerhalb des Resonators beeinflussen.

Vorzugsweise verjüngt sich die trapezförmige Gewinnsektion vom ersten Ende (Austrittsfacette) zum zweiten Ende hin. Vorzugsweise verjüngt sich die trapezförmige Gewinnsektion kontinuierlich vom ersten Ende (Austrittsfacette) zum zweiten Ende hin. Erfindungsgemäß muss die Gewinnsektion nicht streng trapezförmig, d.h. mit planaren Kanten ausgebildet sein. Es ist alternativ möglich, dass die Seitenflächen nicht planar ausgebildet sind. Vorzugsweise ist die gesamte Gewinnsektion jedoch exakt als Trapez ausgebildet.

Vorzugsweise weist der erste planaren Bragg Reflektor (im Bereich der Austrittsfacette) eine geringere Reflektivität als der zweite planaren Bragg Reflektor auf. Vorzugsweise stimmt die Breite des zweiten planaren Bragg Reflektors mit der Breite der Gewinnsektion im Bereich des zweiten Endes überein.

Der erfindungsgemäße Diodenlaser weist den erfindungsgemäßen Resonator mit mindestens einem der vorgenannten Merkmale auf. Vorzugsweise ist das Verhältnis der Breite des ersten planaren Bragg Reflektors zur Breite des zweiten planaren Bragg Reflektors (unter Berücksichtigung der Resonatortänge sowie der Dimensionen und Materialien der Wellenleiterschichten) derart gewählt, dass das Verhältnis des Propagationsfaktors der lateralen Grundmode zum Propagationsfaktor der lateralen Mode erster Ordnung (bzw. aller Propagationsfaktor von lateralen Mode höherer Ordnungen) größer als 5, bevorzugt größer als 8, noch bevorzugter größer als 10 und noch bevorzugter größer als 11 ist.

Als ein Rippenwellenleiter im Sinne der vorliegenden Erfindung wird ein Abschnitt des Wellenleiters verstanden, der entlang einer vertikalen Achse unterschiedliche Breiten aufweist.

Gemäß einem weiteren Aspekt der Erfindung weist ein Laserresonator für eine Laserdiode eine Gewinnsektion, einen ersten planaren Bragg Reflektor und einen zweiten planaren Bragg Reflektor auf, wobei die Gewinnsektion trapezförmig ausgebildet ist, und der erste planare Bragg Reflektor an einer ersten Grundseite der trapezförmigen Gewinnsektion und der zweite planare Bragg Reflektor an der gegenüberliegenden Grundseite der trapezförmigen Gewinnsektion angeordnet sind, wobei sich die Breite des ersten planaren Bragg Reflektors von der Breite des zweiten planaren Bragg Reflektors unterscheidet.

Vorzugsweise ist die gesamte Gewinnsektion trapezförmig ausgebildet ist. Vorzugsweise beträgt das Verhältnis der Breite des zweiten planaren Bragg Reflektors zur Breite des ersten planaren Bragg Reflektors zwischen 1,5 und 20. Vorzugsweise sind die Bragg Reflektoren als Oberflächengitter mit Gitterfurchen mit vollständig geradlinigen Kanten entlang einer Achse senkrecht zur Lichtausbreitungsrichtung und parallel zur Ebene der Wellenleiterschichten des Resonators ausgebildet. Vorzugsweise sind die Bragg Reflektoren als internes Gitter mit vollständig geradlinigen Kanten entlang einer Achse senkrecht zur Lichtausbreitungsrichtung und parallel zur Ebene der Wellenleiterschichten des Resonators ausgebildet. Vorzugsweise weist der Laserresonator am äußeren Ende des ersten Bragg Reflektors eine erste Facette und äußeren Ende des zweiten Bragg Reflektors eine zweite Facette aufweist. Vorzugsweise ist im Bereich zwischen dem ersten Bragg Reflektor und dem zweiten Bragg Reflektor kein Rippenwellenleiter angeordnet. Vorzugsweise sind die erste Facette und/oder die zweite Facette planar ausgebildet. Vorzugsweise weisen die erste Facette und/oder die zweite Facette eine Reflexion von kleiner als 1% für spezifische Laserwellenlänge der Gewinnsektion auf. Vorzugsweise weisen die erste Facette und/oder die zweite Facette eine Reflexion von kleiner als 0.1 % für spezifische Laserwellenlänge der Gewinnsektion auf. Vorzugsweise verjüngt sich die trapezförmige Gewinnsektion vom ersten Ende zum zweiten Ende hin. Vorzugsweise weist der erste planaren Bragg Reflektor für spezifische Laserwellenlänge der Gewinnsektion eine geringere Reflektivität als der zweite planaren Bragg Reflektor auf. Vorzugsweise stimmt die Breite des zweiten planaren Bragg Reflektors mit der Breite der Gewinnsektion im Bereich des zweiten Endes überein. Vorzugsweise sind der erste planare Bragg Reflektor und/oder der zweite planare Bragg Reflektor durch periodische Variation der Brechzahl zwischen zwei Werten und entlang der Längsachse des Resonators ausgebildet, wobei die Periodenlänge und Brechzahlen derart gewählt sind, dass die Zentralwellenlänge des Bragg Reflektors im Verstärkungsspektrum der Gewinnsektion liegt. Vorzugsweise weisen die Bragg Reflektoren Gitterfurchen mit geradlinigen Kanten entlang einer Achse senkrecht zur Lichtausbreitungsrichtung und senkrecht zur Ebene der Wellenleiterschichten auf. Vorzugsweise sind der erste planare Bragg Reflektor und der zweite planare Bragg Reflektor zumindest teilweise innerhalb einer der Wellenleiterschichten des Resonators ausgebildet. Vorzugsweise besteht der Laserresonator aus genau zwei Bragg Reflektoren.

Gemäß einem weiteren Aspekt der Erfindung weist ein Laserresonator mit mindestens einem der oben genannten Merkmale auf, wobei elektrische Kontakte zur Injektion elektrischer Ladungsträger in die Gewinnsektion vorgesehen sind. Vorzugsweise ist die gesamte Gewinnsektion gewinngeführt ausgebildet. Gemäß einem weiteren Aspekt der Erfindung wird der Diodenlasers ohne einen zusätzlichen, externen Resonator zur Erzeugung von Laserstrahlung verwendet.

Kurze Beschreibung der Figuren

Die Erfindung wird nachfolgend anhand von in den Figuren dargestellten Ausführungsbeispielen näher erläutert.

Es zeigen:

Fig. 1      eine schematische Darstellung eines erfindungsgemäßen Resonators in Draufsicht,

Fig. 2      eine schematische Darstellung eines erfindungsgemäßen Resonators gemäß einer ersten Ausführungsvariante in Schnittdarstellung,

Fig. 3      eine schematische Darstellung eines erfindungsgemäßen Resonators gemäß einer zweiten Ausführungsvariante in Schnittdarstellung, und

Fig. 4 die Abhängigkeit der Propagationsfaktoren der lateralen Grundmode sowie der lateralen Mode erster Ordnung vom Breitenverhältnis der im Resonator verwendeten Bragg Reflektoren.

Detaillierte Beschreibung der Figuren

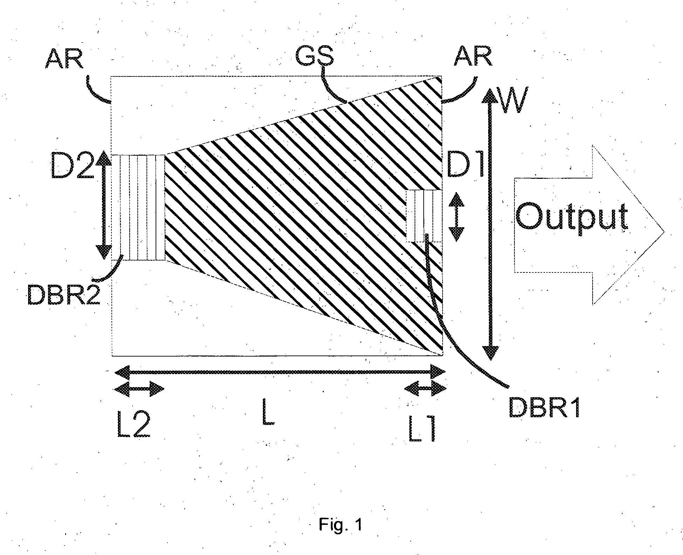

Fig. 1 zeigt eine schematische Darstellung eines erfindungsgemäßen Resonators gemäß einer bevorzugten Ausführungsvariante der Erfindung. Der optische Resonator (einer erfindungsgemäßen Hochleistungslaserdiode) wird durch zwei planare Bragg Reflektoren DBR1 und DBR2 unterschiedlicher Breite $D_1$ und $D_2$ gebildet, zwischen denen sich eine elektrisch gepumpte, trapezförmige Gewinnsektion GS befindet. Die Facetten AR sind hochgradig entspiegelt. Die Abstrahlung (Output) erfolgt an der Facette bei DBR1.

Instabile Resonatoren mit gekrümmten Spiegeln sind im Stand der Technik hinlänglich bekannt. Gemäß der Erfindung ist es jedoch vorgesehen, dass anstatt gekrümmter Spiegel planare Bragg-Spiegel zur Erzeugung des instabilen Resonators verwendet werden. Die Verwendung von planaren Gittern als Reflektoren umgeht die technologischen Schwierigkeiten, die bei der Verwendung von gekrümmten Bragg-Gittern oder gekrümmten Facetten entstehen. Es konnte gefunden werden, dass die Verwendung planarer Bragg-Spiegel unterschiedlicher Breite (und vorzugsweise gleicher Gitterkonstante und gleichen Materials) zu einer erhöhten lateralen Strahlqualität führt, sofern das Breitenverhältnis geeignet gewählt wird.

Die Krümmung der Wellenfronten wird erfindungsgemäß nicht durch gekrümmte Spiegel, sondern durch Beugung an den planaren, räumlich begrenzten Spiegeln erreicht.

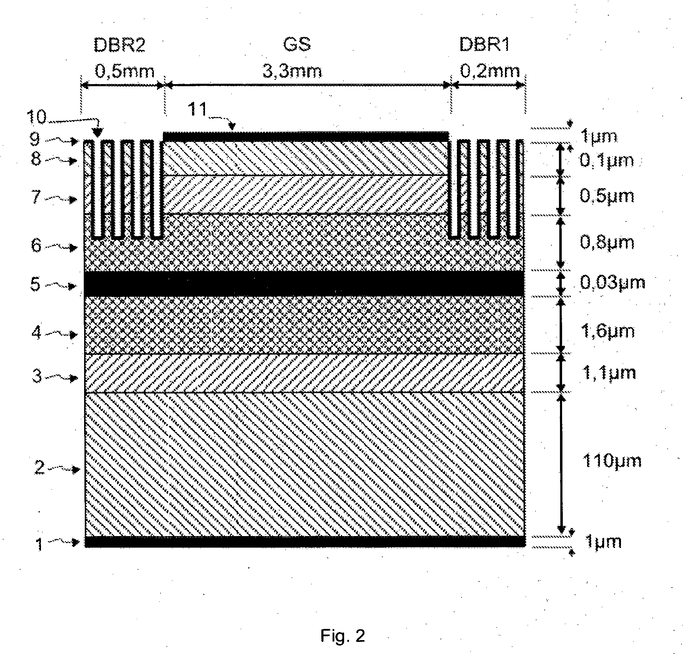

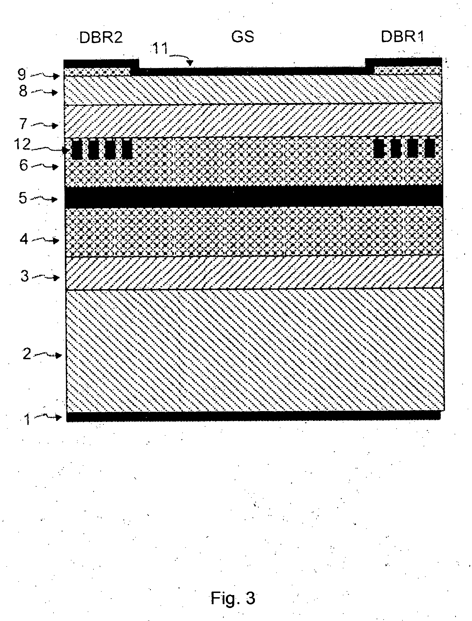

Fig. 2 und 3 zeigen unterschiedliche, bevorzugte Ausführungsvarianten eines erfindungsgemäßen Resonators in Schnittdarstellung.

Auf einem Substrat 2 werden nachfolgend die eine n-Mantelschicht 3, ein n-Wellenleiter 4, eine aktive Schicht 5, ein p-Wellenleiter 6, eine p-Mantelschicht 7, eine Kontaktschicht 8 sowie im Bereich der Gitter DBR1 und DBR2 jeweils ein Isolator 9 aufgebracht. Die bevorzugten Materialien ergeben sich aus der Bezugszeichenliste, die bevorzugten Schichtdicken ergeben sich aus den Fig. 2 und 3. Weiterhin werden zur Kontaktierung eine n-Metallisierung 1 auf der Unterseite des Substrats 2 sowie eine p-Metallisierung 11 aufgebracht. Sofern die Bragg Reflektoren DBR1 und DBR2 als Oberflächengitter 10 (Fig. 2) in die zuvor prozessierten Schichten 2 bis 8 des Resonators eingeätzt werden, erstrecken sich die Gitterfurchen der Bragg Reflektoren DBR1 und DBR2 jeweils über mindestens einen Teil der oberen Wellenleiterschicht 6, die Mantelschicht 7 sowie die Kontaktschicht 8. Erfindungsgemäß sind die Kanten Gitterfurchen der Bragg Reflektoren DBR1 und DBR2 vollständig planar ausgebildet. Zumindest ist es erforderlich, dass die Kanten der Gitterfurchen vollständig geradlinig entlang einer Achse senkrecht zur Lichtausbreitungsrichtung und parallel zur Ebene der Wellenleiterschichten 4, 6 ausgebildet sind. Gleiches gilt für die Kanten der internen Gitter 12 in Fig. 3. In dieser Ausführungsvariante werden die Bragg Reflektoren DBR1 und DBR2 während des Aufbringens der einzelnen Wellenleiterschicht 6 als eingeschlossenes Gitter 12 erzeugt, die sich innerhalb der Wellenleiterschicht 6 mit geradlinigen Kanten erstrecken.

Besonders bevorzuge Dimensionen sind:

| L=4mm | L=6mm | L=8mm |
|---|---|---|
| W=200$\mu$m | W=250$\mu$m | W=500$\mu$m |
| D1=20$\mu$m | D1 =20$\mu$m | D1=20$\mu$m |
| D2=75$\mu$m | D2=90$\mu$m | D2=165$\mu$m |
| L1=200$\mu$m | L1=200$\mu$m | L1=500$\mu$m |
| L2=500$\mu$m | L2=1000$\mu$m | L2=1000$\mu$m |

Allgemein gelten bevorzugt folgende Verhältnisse: L1/L2 beträgt bevorzugt zwischen 0,1 und 1,0 und noch bevorzugter zwischen 0,2 und 0,5. D2/D1 beträgt bevorzugt zwischen 2 und 20 und noch bevorzugter zwischen 3 und 9. L/L1 beträgt bevorzugt zwischen 10 und 40 und noch bevorzugter zwischen 15 und 30. Allgemein gelten bevorzugt folgende Abmessungen: L1 beträgt bevorzugt zwischen 100 $\mu$m und 1000 $\mu$m und noch bevorzugter zwischen 200 $\mu$m und 500 $\mu$m. L2 beträgt bevorzugt zwischen 200 $\mu$m und 2000 $\mu$m und noch bevorzugter zwischen 500 $\mu$m und 1000 $\mu$m. L beträgt bevorzugt zwischen 2 mm und 10 mm und noch bevorzugter zwischen 4 mm und 8 mm. D1 beträgt bevorzugt zwischen 10 $\mu$m und 50 $\mu$m und noch bevorzugter zwischen 15 $\mu$m und 25 $\mu$m. D1 beträgt bevorzugt zwischen 50 $\mu$m und 250 $\mu$m und noch bevorzugter zwischen 75 $\mu$m und 165 $\mu$m.

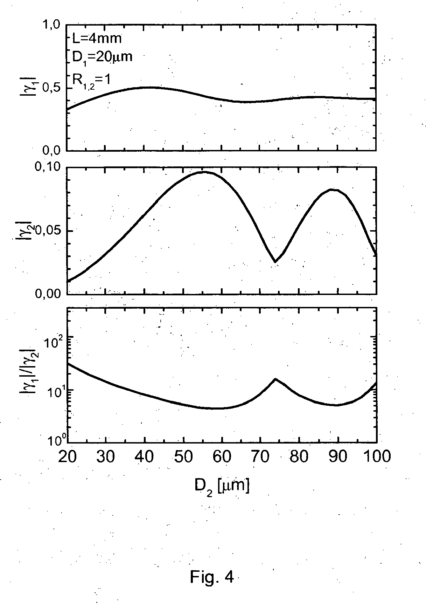

Fig. 4 zeigt eine numerische Simulation eines instabiler Resonator mit planaren Gittern, insbesondere: a) die Abhängigkeit des Propagationsfaktors der lateralen Grundmode von der Rückgitterbreite $D_2$, b) die Abhängigkeit des Propagationsfaktors der lateralen Mode erster Ordnung von der Rückgitterbreite $D_2$, und c) die Abhängigkeit der Modendiskriminierung in Abhängigkeit von Rückgitterbreite $D_2$, jeweils bei einer Wellenlänge von 1060nm, einer Resonatorlänge von 4 mm und einer Rückgitterbreite D1 von 20 $\mu$m. Die Reflektivitäten der Gitter DBR1 und DBR2 wurden jeweils R=1 angenommen.

Die numerische Simulationen belegen, dass es bei Variation der Rückgitterbreite $D_2$ zur Modulation der Propagationsfaktoren und somit auch Modulation der modalen Verluste der transversalen Resonatormoden kommt. Da die Maxima und Minima der Verluste der einzelnen Moden bei unterschiedlichen Gitterbreiten D1,$D_2$ auftreten, kann bei korrekter Wahl der Gitterbreiten und der Resonatorlänge eine erhöhe Modendiskriminierung derart erreicht werden, dass lateraler Moden höherer Ordnung stärker unterdrückt werden.

Das optimale Verhältnis von $D_2$/D1 hängt von der Resonatorlänge sowie der Wellenlänge des Lichts im Resonator ab. Da eine analytische Lösung der Resonatorsimulation für räumlich begrenzte Spiegel nicht möglich ist, kann das optimale Verhältnis von $D_2/D_1$ durch eine numerische Resonatorsimulation erfolgen. Für die charakteristischen, bevorzugten Dimensionen von Hochleistungsdiodenlasern (Länge 0.5 bis 10mm) liegt das Verhältnis $D_2/D_1$ vorzugsweise im Bereich zwischen 1,5 und 20, noch bevorzugter im Bereich zwischen 3 und 10 und noch bevorzugter im Bereich zwischen 3 und 7. Für die bevorzugte Realisierung eines 4mm langen Lasers bei 1 $\mu$m Wellenlänge sind bevorzugt mit $D_2$=75$\mu$m und $D_1$=20$\mu$m ausgebildet.

MOPAs basieren im Gegensatz zur vorliegenden Erfindung nicht auf instabilen Resonatoren, sondern auf der lateralen Einmodigkeit des Master-Oszillators. Diese wird durch die geringe laterale Breite des Rippenwellenleiters erreicht. Durch die größere Pumpfläche und dem damit verbundenen kleineren elektrischen Serienwiderstands und thermischen Widerstands können mit der vorliegenden Erfindung im Vergleich zum Trapez-MOPA bei gleicher Länge wesentlich höhere Leistungen erzielt werden. Des Weiteren entfallen bei der vorliegenden Erfindung die Probleme durch optische Rückkopplung in den Master-Oscillator.

Beim Trapezlaser besteht eine Sektion des Laserresonators aus einem schmalen Rippenwellenleiter als Modenfilter. Ebenso basiert die Modenfilterung bei den aus Bedford et al. "Demonstration of finite-aperture tapered unstable resonator lasers", Applied Physics Letters, Vol. 83, No. 5, bekannten DBR-Trapezlaser auf der Verwendung einer Rippenwellenleiter-Sektion, so dass beim Diodenlaser gemäß der vorliegenden Erfindung eine größere Pumpfläche zur Verfügung steht.

Bezugszeichenliste

GS     Gewinnsektion
DBR1   erster planarer Bragg Reflektor
DBR2   zweiter planarer Bragg Reflektor
D1     Breite des ersten planaren Bragg Reflektor
D2     Breite des zweiten planaren Bragg Reflektor
L1     Länge des ersten planaren Bragg Reflektors
L2     Länge des zweiten planaren Bragg Reflektors
W      Breite der Frontapertur
L      Gesamtlänge des Laserresonators
AR     Facette

1      n-Metallisierung
2      Substrat (z.B. GaAs)
3      n-Mantelschicht (z.B. AlGaAs)
4      n-Wellenleiter (z.B. GaAs)
5      Aktive Zone (z.B. mehrfach-Quantengräben InGaAs/GaAs)
6      p-Wellenleiter (z.B. GaAs)
7      p-Mantelschicht (z.B. AlGaAs)
8      Kontaktschicht (z.B. GaAs)
9      Isolator (z.B. SiN)
10     Bragg-Reflektor: Oberflächengitter
11     p-Metallisierung
12     Bragg Reflektor: internes Gitter (z.B. GaAsP)

**Patentansprüche**

1. Laserresonator für eine Laserdiode, aufweisend:

   eine Gewinnsektion (GS),
   einen ersten planaren Bragg Reflektor (DBR1) und einen zweiten planaren Bragg Reflektor (DBR2),
   wobei die Gewinnsektion (GS) zwischen dem ersten planaren Bragg Reflektor (DBR1 ) und dem zweiten planaren Bragg Reflektor (DBR2) angeordnet ist, wobei
   die gesamte Gewinnsektion (GS) gewinngeführt ausgebildet ist, und sich die Breite (D1) des ersten planaren Bragg Reflektors (DBR1) von der Breite (D2) des zweiten planaren Bragg Reflektors (DBR2) unterscheidet.

2. Laserresonator nach einem der vorhergehenden Ansprüche,
   **dadurch gekennzeichnet, dass**
   das Verhältnis der Breite (D2) des zweiten planaren Bragg Reflektors (DBR2) zur Breite (D1) des ersten planaren Bragg Reflektors (DBR1) zwischen 1,5 und 20 beträgt.

3. Laserresonator nach Anspruch 2,
   **dadurch gekennzeichnet; dass**
   das Verhältnis der Breite (D2) des zweiten planaren Bragg Reflektors (DBR2) zur Breite (D1) des ersten planaren Bragg Reflektors (DBR1) zwischen 3 und 10 beträgt.

4. Laserresonator nach einem der vorhergehenden Ansprüche,
   **dadurch gekennzeichnet, dass**
   die Bragg Reflektoren (DBR1, DBR2) als Oberflächengitter (10) mit Gitterfurchen mit vollständig geradlinigen Kanten entlang einer Achse senkrecht zur Lichtausbreitungsrichtung und parallel zur Ebene der Wellenleiterschichten (4, 6) des Resonators ausgebildet sind.

5. Laserresonator nach einem der vorhergehenden Ansprüche,
   **dadurch gekennzeichnet, dass**
   der Laserresonator an einem äußeren Ende des ersten Bragg Reflektors (DBR1) eine erste Facette (AR) und an einem äußeren Ende des zweiten Bragg Reflektors (DBR2) eine zweite Facette (AR) aufweist.

6. Laserresonator nach Anspruch 5,
   **dadurch gekennzeichnet, dass**
   die erste Facette (AR) und/oder die zweite Facette (AR) planar ausgebildet ist und/oder eine Reflexion von kleiner als 1% für spezifische Laserwellenlänge der Gewinnsektion (GS) aufweist.

7. Laserresonator nach einem der vorhergehenden Ansprüche,
   **dadurch gekennzeichnet, dass**
   sich die Gewinnsektion (GS) von einem ersten Ende, an dem der erste planare Bragg Reflektor (DBR1) angeordnet ist, zu einem zweiten Ende, an dem der zweite planare Bragg Reflektor (DBR2) angeordnet ist, hin verjüngt.

8. Laserresonator nach einem der vorhergehenden Ansprüche,
   **dadurch gekennzeichnet, dass**
   die Breite des zweiten planaren Bragg Reflektors (DBR2) mit der Breite der Gewinnsektion (GS) im Bereich des zweiten Endes übereinstimmt.

9. Laserresonator nach einem der vorhergehenden Ansprüche,
   **dadurch gekennzeichnet, dass**
   der erste planare Bragg Reflektor (DBR1) und/oder der zweite planare Bragg Reflektor (DBR2) durch periodische Variation der Brechzahl zwischen zwei Werten und entlang der. Längsachse des Resonators ausgebildet sind, wobei die Periodenlänge und Brechzahlen derart gewählt sind, dass die Zentralwellenlänge des Bragg Reflektors (DBR1, DBR2) im Verstärkungsspektrum der Gewinnsektion (GS) liegt.

10. Laserresonator nach einem der vorhergehenden Ansprüche,
    **dadurch gekennzeichnet, dass**
    die Bragg Reflektoren (DBR1, DBR2) Gitterfurchen mit geradlinigen Kanten entlang einer Achse senkrecht zur Lichtausbreitungsrichtung und senkrecht zur Ebene der Wellenleiterschichten (4, 6) aufweisen.

**11.** Laserresonator nach einem der vorhergehenden Ansprüche,
**dadurch gekennzeichnet, dass**
der erste planare Bragg Reflektor (DBR1) und der zweite planare Bragg Reflektor (DBR2) zumindest teilweise innerhalb einer der Wellenleiterschichten (6) des Resonators ausgebildet sind.

**12.** Laserresonator nach einem der vorhergehenden Ansprüche,
**dadurch gekennzeichnet, dass**
der Laserresonator aus genau zwei Bragg Reflektoren (DBR1, DBR2) besteht.

**13.** Diodenlaser, aufweisend:

einen Laserresonator nach einem der Patentansprüche 1 bis 12, und
elektrische Kontakte (1, 11) zur Injektion elektrischer Ladungsträger in die Gewinnsektion (GS).

**14.** Diodenlaser nach Anspruch 13,
**dadurch gekennzeichnet, dass**
die gesamte Gewinnsektion (GS) gewinngeführt ist.

**15.** Verwendung eines Diodenlasers nach einem der Patentansprüche 13 bis 14 ohne einen zusätzlichen, externen Resonator zur Erzeugung von Laserstrahlung.


**Claims**

**1.** A laser resonator for a laser diode, comprising:

a gain section (GS),
a first planar Bragg reflector (DBR1) and a second planar Bragg reflector (DBR2),
wherein the gain section (GS) is arranged between the first planar Bragg reflector (DBR1) and the second planar Bragg reflector (DBR2), wherein the entire gain section (GS) has a gain-guided design and the width (D1) of the first planar Bragg reflector (DBR1) differs from the width (D2) of the second planar Bragg reflector (DBR2).

**2.** The laser resonator according to any one of the preceding claims, **characterized in that**
the ratio of the width (D2) of the second planar Bragg reflector (DBR2) to the width (D1) of the first planar Bragg reflector (DBR1) is between 1.5 and 20.

**3.** The laser resonator according to Claim 2,
**characterized in that**
the ratio of the width (D2) of the second planar Bragg reflector (DBR2) to the width (D1) of the first planar Bragg reflector (DBR1) is between 3 and 10.

**4.** The laser resonator according to any one of the preceding claims, **characterized in that**
the Bragg reflectors (DBR1, DBR2) are designed as surface gratings (10) having grating grooves with completely straight edges along an axis perpendicular to the direction of propagation of light and parallel to the plane of the waveguide layers (4, 6) of the resonator.

**5.** The laser resonator according to any one of the preceding claims, **characterized in that**
the laser resonator comprises a first facet (AR) on an outer end of the first Bragg reflector (DBR1) and a second facet (AR) on an outer end of the second Bragg reflector (DBR2).

**6.** The laser resonator according to Claim 5,
**characterized in that**
the first facet (AR) and/or the second facet (AR) has/have a planar design and/or a reflection of less than 1% for the specific laser wavelength of the gain section (GS).

**7.** The laser resonator according to any one of the preceding claims, **characterized in that**
the gain section (GS) tapers from a first end, on which the first planar Bragg reflector (DBR1) is arranged, towards a second end, on which the second planar Bragg reflector (DBR2) is arranged.

8. The laser resonator according to any one of the preceding claims, **characterized in that** the width of the second planar Bragg reflector (DBR2) is the same as the width of the gain section (GS) in the area of the second end.

9. The laser resonator according to any one of the preceding claims, **characterized in that** the first planar Bragg reflector (DBR1) and/or the second planar Bragg reflector (DBR2) is/are formed by means of a periodic variation of the refractive index between two values and along the longitudinal axis of the resonator, wherein the period length and refractive indices are selected in such a manner that the central wavelength of the Bragg reflector (DBR1, DBR2) is within the amplification spectrum of the gain section (GS).

10. The laser resonator according to any one of the preceding claims, **characterized in that** the Bragg reflectors (DBR1, DBR2) comprise grating grooves with straight edges along an axis perpendicular to the direction of propagation of light and perpendicular to the plane of the waveguide layers (4, 6).

11. The laser resonator according to any one of the preceding claims, **characterized in that** the first planar Bragg reflector (DBR1) and the second planar Bragg reflector (DBR2) are formed at least partly within one of the waveguide layers (6) of the resonator.

12. The laser resonator according to any one of the preceding claims, **characterized in that** the laser resonator consists of exactly two Bragg reflectors (DBR1, DBR2).

13. A diode laser, comprising:

   a laser resonator according to any one of Claims 1 to 12, and electrical contacts (1, 11) for injecting electrical charge carriers into the gain section (GS).

14. The diode laser according to Claim 13,
   **characterized in that**
   the entire gain section (GS) is gain-guided.

15. Use of a diode laser according to any one of Claims 13 to 14 without an additional external resonator for producing laser radiation.


**Revendications**

1. Résonateur de laser pour une diode de laser, présentant :

   une section gain (GS),
   un premier réflecteur de Bragg (DBR1) plan et un deuxième réflecteur de Bragg (DBR2) plan,
   la section gain (GS) étant disposée entre le premier réflecteur de Bragg (DBR1) plan et le deuxième réflecteur de Bragg (DBR2) plan,
   la totalité de la section gain (GS) étant constituée de façon guidée par le gain, et la largeur (D1) du premier réflecteur de Bragg (DBR1) plan étant différente de la largeur (D2) du deuxième réflecteur de Bragg (DBR2) plan.

2. Résonateur de laser selon l'une des revendications précédentes,
   **caractérisé en ce que**
   le rapport de la largeur (D2) du deuxième réflecteur de Bragg (DBR2) plan à la largeur (D1) du premier réflecteur de Bragg (DBR1) plan est compris entre 1,5 et 20.

3. Résonateur de laser selon la revendication 2,
   **caractérisé en ce que**
   le rapport de la largeur (D2) du deuxième réflecteur de Bragg (DBR2) plan à la largeur (D1) du premier réflecteur de Bragg (DBR1) plan est compris entre 3 et 10.

4. Résonateur de laser selon l'une des revendications précédentes,
   **caractérisé en ce que**
   les réflecteurs de Bragg (DBR1, DBR2) sont constitués en tant que réseau de surface (10) avec des sillons de réseau avec des arêtes totalement rectilignes le long d'un axe perpendiculairement à la direction de propagation de la lumière et parallèlement au plan des couches de guide d'ondes (4, 6) du résonateur.

5. Résonateur de laser selon l'une des revendications précédentes,
**caractérisé en ce que**
le résonateur de laser présente à une extrémité extérieure du premier réflecteur de Bragg (DBR1) une première facette (AR) et, à une extrémité extérieure du deuxième réflecteur de Bragg (DBR2), une deuxième facette (AR).

6. Résonateur de laser selon la revendication 5,
**caractérisé en ce que**
la première facette (AR) et/ou la deuxième facette (AR) est constituée de façon plane et/ou présente une réflexion inférieure à 1 % pour la longueur d'onde laser spécifique de la section gain (GS).

7. Résonateur de laser selon l'une des revendications précédentes,
**caractérisé en ce que**
la section gain (GS) se rétrécit à partir d'une première extrémité sur laquelle est disposé le premier réflecteur de Bragg (DBR1) plan vers une deuxième extrémité sur laquelle est disposé le deuxième réflecteur de Bragg (DBR2) plan.

8. Résonateur de laser selon l'une des revendications précédentes,
**caractérisé en ce que**
la largeur du deuxième réflecteur de Bragg (DBR2) plan coïncide avec la largeur de la section gain (GS) dans la région de la deuxième extrémité.

9. Résonateur de laser selon l'une des revendications précédentes,
**caractérisé en ce que**
le premier réflecteur de Bragg (DBR1) plan et/ou le deuxième réflecteur de Bragg (DBR2) plan sont constitués par une variation périodique de l'indice de réfraction entre deux valeurs et le long de l'axe longitudinal du résonateur, la longueur de période et les indices de réfraction étant choisis de telle sorte que la longueur d'onde centrale du réflecteur de Bragg (DBR1, DBR2) se situe dans le spectre d'amplification de la section gain (GS).

10. Résonateur de laser selon l'une des revendications précédentes,
**caractérisé en ce que**
les réflecteurs de Bragg (DBR1, DBR2) présentent des sillons de réseau avec des arêtes rectilignes le long d'un axe perpendiculairement à la direction de propagation de la lumière et perpendiculairement au plan des couches de guide d'ondes (4, 6).

11. Résonateur de laser selon l'une des revendications précédentes,
**caractérisé en ce que**
le premier réflecteur de Bragg (DBR1) plan et le deuxième réflecteur de Bragg (DBR2) plan sont constitués au moins partiellement à l'intérieur d'une des couches de guide d'ondes (6) du résonateur.

12. Résonateur de laser selon l'une des revendications précédentes,
**caractérisé en ce que**
le résonateur de laser se compose de précisément deux réflecteurs de Bragg (DBR1, DBR2).

13. Laser à diode, présentant :

un résonateur de laser selon l'une des revendications 1 à 12, et
des contacts électriques (1, 11) pour l'injection de supports de charge électriques dans la section gain (GS).

14. Laser à diode selon la revendication 13,
**caractérisé en ce que**
la totalité de la section gain (GS) est guidée par le gain.

15. Utilisation d'un laser à diode selon l'une des revendications 13 à 14 sans résonateur externe supplémentaire pour la production du rayonnement laser.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **AUS ERIKSSON et al.** Surface-Emitting Unstable Resonator Lasers with Integrated Diffractive Beam-Forming Elements. *IEEE Photonics Technology Letters,* Dezember 1997, vol. 9 (12), 1570-1572
- **BEDFORD et al.** Demonstration of finite-aperture tapered unstable resonator lasers. *Applied Physics Letters,* vol. 83 (5
- **M. UENO ; H. YONEZU.** Guiding mechanisms controlled by impurity concentrations - (AI,Ga)As planar stripe laser with deep Zn diffusion. *J. Appl. Phys.,* 1980, vol. 51 (5), 2361-2371
- **M. YAMADA.** Transverse and Longitudinal Mode Control in Semiconductor Injection Lasers. *J. Quant. Electron. QE,* 1983, vol. 19 (9), 1365-1380